Europäisches Patentamt

European Patent Office

Office européen des brevets

(11) Publication number: **0 383 455**
**A1**

## EUROPEAN PATENT APPLICATION

(21) Application number: 90300999.1

(22) Date of filing: 31.01.90

(51) Int. Cl.⁵: **H03K 5/15**

(30) Priority: 16.02.89 US 311265

(43) Date of publication of application:
22.08.90 Bulletin 90/34

(84) Designated Contracting States:
AT BE CH DE DK ES FR GB GR IT LI LU NL SE

(71) Applicant: **ADVANCED MICRO DEVICES, INC.**
**901 Thompson Place P.O. Box 3453**
**Sunnyvale, CA 94088(US)**

(72) Inventor: **Woo, Ann K.**
**22997 Standing Oak Court**
**Cupertino, California(US)**

(74) Representative: **Wright, Hugh Ronald et al**
**Brookes & Martin 52/54 High Holborn**
**London WC1V 6SE(GB)**

(54) **Two-phase clock driver.**

(57) A clock driver for generating two phases, each of the phases having a pulse width that is minimally different from one another. The driver has an input clock signal (CLOCK) with a predetermined pulse width and a device (42, 44) for receiving the input clock signal and for generating a first output clock signal (CK). The first output clock signal (CK) is buffered and delayed relative to the input clock (CLOCK) signal by the receiving device (42, 44). But the first output clock (CK) signal has the same predetermined pulse width as the input clock signal (CLOCK). A device (46) is also provided for receiving the input clock signal (CLOCK) and the first output clock signal (CK) and for generating a second output clock signal (CKB) out of phase with respect to the first output clock signal (CK). The second output clock signal (CKB) has a pulse width different than the predetermined pulse width of the input clock signal (CLOCK).

FIG.3

## TWO-PHASE CLOCK DRIVER

The present invention relates to clock drivers such as clock drivers requiring relatively low power and capable of operating at relatively high frequencies.

In bipolar technology, relatively high power is often required and, fortunately, available to drive electronic components and circuitry. Significant power makes high frequency switching possible in logic systems.

Unlike bipolar technology, however, where power is supplied continuously to electronic semiconductor components, in MOS or CMOS technology power is applied only when a device is active. Much lower power is therefore required to operate CMOS components, since they do not consume power when not in use.

Unfortunately, the lower power requirements in CMOS technology usually also reflect a lower operating or switching frequency. Thus the relationship between power and switching speed for bipolar and CMOS technologies can be stated as follows: high power devices (e.g., bipolar) generally operate at higher speeds; low power devices (e.g., CMOS) generally operate at lower speeds.

Systems have been developed to amplify power, of course, but they tend to be expensive, multi-component systems that are prone to failure and contribute to time delays. In general, the greater the number of components, the greater the likelihood of such adverse side effects.

A two-phase clock signal is most usable when both phases thereof (known as the CLOCK and the inverted CLOCK or CLOCK BAR signal) are distinct and non-overlapping. At higher frequencies of operation, however, conventional low power CMOS circuits cannot function optimally due to unequal pulse widths of the phases. A solution to the foregoing problem at frequencies over 100 MHz in CMOS circuit clock drivers has heretofore eluded designers.

It would be advantageous to provide a system using components that require low power but that are still capable of operating at higher speeds, on the order of 100 MHz.

It would also be advantageous to provide a system for driving a clock signal comprising a small number of components.

It would also be advantageous to provide a simple system for ensuring that there is no overlap between a CLOCK and a CLOCK BAR signal even at high frequencies.

It would also be advantageous to provide a system for guaranteeing more equal pulse widths of clock phases at high operating frequencies.

## SUMMARY OF THE INVENTION

In accordance with the present invention, there is provided a clock driver for generating two phases, each of the phases having a pulse width that is minimally different from one another. The driver has an input clock signal with a predetermined pulse width and a device for receiving the input clock signal and for generating a first output clock signal. The first output clock signal is buffered and delayed relative to the input clock signal by the receiving device. But the first output clock signal has the same predetermined pulse width as the input clock signal. A device is also provided for receiving the input clock signal and the first output clock signal and for generating a second output clock signal out of phase with respect to the first output clock signal. The second output clock signal has a pulse width different than the predetermined pulse width of the input clock signal.

## BRIEF DESCRIPTION OF THE DRAWINGS

A complete understanding of the present invention may be obtained by reference to the accompanying drawings, when taken in conjunction with the detailed description thereof and in which:

FIGURE 1 is a schematic diagram of a typical clock driver used with MOS or CMOS devices in the prior art;

FIGURE 2 is a timing diagram showing the operation of the conventional circuit shown in FIGURE 1;

FIGURE 3 is a schematic diagram of the clock driver in accordance with the present invention; and

FIGURE 4 is a timing diagram showing operation of a clock driver of the present invention.

## DESCRIPTION OF THE PREFERRED EMBODIMENT

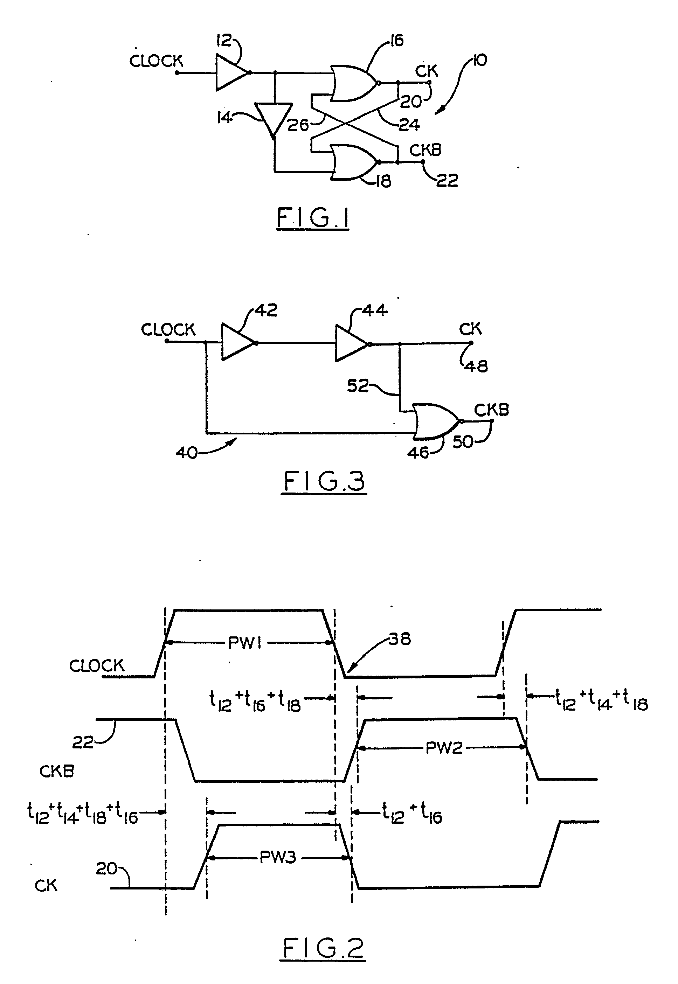

Referring now to FIGURE 1 there is shown a schematic diagram of a clock driver of the prior art. In MOS or CMOS technology, a two-phase clock is commonly used to drive dynamic shift registers, known as DRAMs. A common implementation of a two-phase clock is an RS flip-flop device, shown generally as reference numeral 10. An inverter 12 is adapted to receive and invert a generated CLOCK signal. Inverter 12 is connected to another inverter 14 and to one input port of a NOR gate 16. Connected to inverter 14 is another NOR gate 18.

The outputs of NOR gates 16 and 18 are applied to terminals 20 and 22, respectively. The output of NOR gate 16 is also applied to one of the input ports of NOR gate 18 by means of line 24, while the output of NOR gate 18 is also applied to one of the input ports of NOR gate 16 by means of line 26.

To distinguish the CLOCK signal applied to circuit 10 from the signal output at terminal 20, the output CLOCK signal is designated CK. The inverted CLOCK signal (commonly known as CLOCK BAR) is designated CKB and is applied to terminal 22.

In operation, when CLOCK signal goes LOW, the signal switches through inverter 12 and NOR gate 16 to generate a LOW CK signal at terminal 20. The LOW CK signal is applied over line 24 to one input port of NOR gate 18 to generate a slightly delayed HIGH CKB signal at terminal 22.

When CLOCK signal goes HIGH, the signal switches through inverters 12 and 14 and NOR gate 18 to generate a LOW CKB signal at terminal 22. The LOW CKB signal is applied over line 26 to NOR gate 16 to generate a slightly delayed HIGH CK signal at terminal 20.

A gate can easily be designed to have the same delay time to turn on as to turn off. If $t_n$ is the propagation delay time of a gate n for either on or off, then referring to FIGURE 2, there are shown timing diagrams of CK and CKB. Their pulse widths are calculated as follows:

$$PW2 = PW1 - (t_{12} + t_{16} + t_{18}) + (t_{12} + t_{14} + t_{18})$$
$$= PW1 - (t_{16} - t_{14})$$
$$PW3 = PW1 - (t_{12} + t_{14} + t_{18} + t_{16}) + (t_{12} + t_{16})$$
$$= PW1 - (t_{14} + t_{18})$$

The fact that one of two outputs 20 or 22 always goes LOW first before the other output 22 or 20 goes HIGH ensures no overlap of both phases at HIGH state, shown generally at reference numeral 38. This does not allow data to be fed through.

At clock frequencies below 50 MHz, the two-phase clock outputs 20 and 22 are close to an ideal 50% duty cycle. As the clock frequency increases and approaches 100 MHz, however, the HIGH CKB signal pulse width PW2 becomes considerably wider than the HIGH state pulse width PW3 of the CK signal. This is due to the two different delay paths, line 24 and gate 18 vs. line 26 and gate 16. It is the narrower HIGH CK signal pulse width PW3, therefore, that limits maximum clock toggling frequency.

In general, if a shift register operates properly with a minimum pulse width of, say, 4 nanoseconds, both of the clock phases should be greater than 4 ns to ensure such proper operation. In the case of the aforementioned prior art circuit 10 (FIGURE 1), a reasonable crossover time period for a 10 ns cycle (100 MHz) would be 2 ns. If the phases are unequal, one of the pulse widths at HIGH state may be less than 4 ns (e.g., 3 ns), while the other pulse width at HIGH state may be greater than 4 ns (e.g., 5 ns in this example).

Thus, although the sum of both pulse widths and delay or crossover time periods is 10 nanoseconds, problems in operation occur due to lack of symmetry. Heretofore, the solution to this problem has been to increase pulse widths arbitrarily, unfortunately reducing the operating frequency. As an example, when a cycle is 12 ns, the maximum operating frequency is 1/12 (83 MHz). The greater the pulse width required, the lower the operating frequency.

Referring now also to FIGURE 3, there is shown a two-phase clock circuit 40 in accordance with the present invention. Circuit 40 is intended to make more uniform the duty cycle of both phases. A first inverter 42 is adapted to receive and invert a CLOCK signal. Inverter 42 is connected to a second inverter 44. The CLOCK signal is also applied to one input port of a NOR gate 46. The outputs of inverter 44 and NOR gate 46 are applied to terminals 48 and 50, respectively. The output of inverter 44 is also applied to the remaining input port of NOR gate 46 by means of line 52.

In operation, when CLOCK signal goes HIGH, CKB signal goes LOW first (before CK signal goes HIGH), because NOR gate 46 switches faster than two inverters 42 and 44 combined. When CLOCK signal goes LOW, CKB signal does not go HIGH until CK signal becomes LOW, since the input to NOR gate 46 over line 52 is not generated until both inverters 42 and 44 are active. Thus, compared to prior art circuits (FIGURE 1), circuit 40 operates with less delay and more uniform pulse width phases.

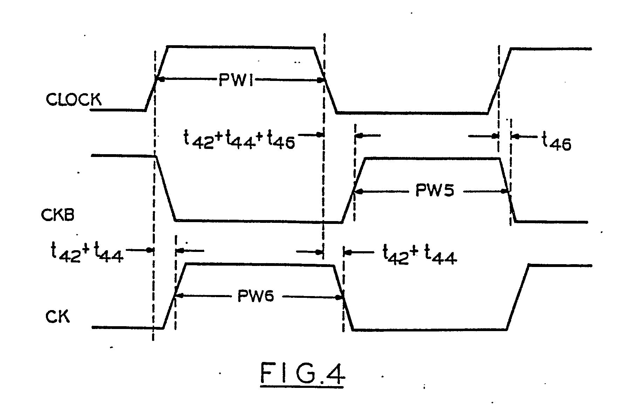

Referring now also to FIGURE 4, there is shown a timing diagram of circuit 40 operation in which the delay contributions of NOR gate 46 and each inverter 42 and 44 are depicted. The equations shown below describe the timing diagram.

$$PW5 = PW1 - (t_{42} + t_{44} + t_{46}) - t_{46} = PW1 - (t_{42} + t_{44})$$
$$PW6 = PW1 - (t_{42} + t_{44}) + (t_{42} + t_{44}) = PW1$$

From circuit simulations, it has been shown that when CLOCK signal operates at a frequency of 100 MHz with a 50% duty cycle, the prior art circuit 10 (FIGURE 1) generates a pulse width of 4.9 ns for CKB signal and 3.5 ns for CK signal, the difference of which is unsuitable for many MOS component circuit applications. For the same CLOCK signal input, the circuit of the present invention 40 (FIGURE 3) generates pulse widths of 5.0 ns for CK signal and 4.1 ns for CKB signal. The maximum CLOCK frequency is therefore improved over that of the prior art circuit 10 by (4.1 - 3.5)/3.5 = 17%.

Since other modifications and changes varied to fit particular operating requirements and environments will be apparent to those skilled in the art, the invention is not considered limited to the example chosen for purposes of disclosure, and covers all changes and modifications which do not constitute departures from the true spirit and scope of this invention.

## Claims

1. A clock driver for generating two phases, each of said phases having a pulse width minimally different from one another, the driver comprising:

a) an input clock signal having a predetermined pulse width;

b) means for receiving said input clock signal and for generating a first output clock signal with said predetermined pulse width, said first output clock signal being buffered and delayed relative to said input clock signal; and

c) means for receiving said input clock signal and said first output clock signal and for generating a second output clock signal being out of phase with respect to said first output clock signal and having a pulse width greater than said predetermined pulse width thereof.

2. The clock driver in accordance with claim 1 wherein said means for receiving said input clock signal comprises two inverters.

3. The clock driver in accordance with claim 2 wherein said means for generating said second output clock signal comprises a NOR gate.

4. The clock driver in accordance with claim 3 wherein said clock driver is adapted to be used with MOS devices for providing relatively high speed operation.

5. The clock driver in accordance with claim 3 wherein each of said inverters and said NOR gate operates with a delay of approximately 0.5 ns.

6. The clock driver in accordance with claim 5 wherein said clock driver generates an output clock signal of approximately 100 MHz.

F I G.1

F I G.3

F I G.2

$$\underline{\text{F I G.4}}$$

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 547 684  (PECHAR)<br>* Figures 2,3; column 2, line 39 - column 3, line 6 * | 1 | H 03 K   5/15 |
| Y | --- | 2-6 | |
| Y | ELECTRONIC DESIGN, vol. 30, no. 26, December 1982, page 181, Waseca, MN, Denville, NJ, US; S. RUBIN: "Simple circuit nests pulse pairs"<br>* Fig.; page 181 * | 2-6 | |

TECHNICAL FIELDS
SEARCHED (Int. Cl.5)

H 03 K

The present search report has been drawn up for all claims

| Place of search | Date of completion of the search | Examiner |
|---|---|---|
| THE HAGUE | 21-05-1990 | FEUER F.S. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................
& : member of the same patent family, corresponding
    document

EPO FORM 1503 03.82 (P0401)